# EUROPÄISCHE PATENTSCHRIFT

(11) **EP 1 849 886 B1**
(45) Veröffentlichungstag und Bekanntmachung des Hinweises auf die Patenterteilung: **08.04.2009**
(21) Anmeldenummer: 07008373.8
(22) Anmeldetag: 25.04.2007
(51) Int. Cl.: C23C 14/32

(54) **Einrichtung und Verfahren zur plasmagestützten Abscheidung von Hartstoffschichten**
Apparatus and method for plasma enhanced deposition of hard material layers
Dispositif et procéde de dépôt par plasma de couches en matériau dur

(30) Priorität: 25.04.2006 DE 102006019000
(43) Veröffentlichungstag der Anmeldung: 31.10.2007
(73) Patentinhaber: VTD Vakuumtechnik Dresden GmbH, 01257 Dresden (DE)
(72) Erfinder: Falz, Michael, Dipl.Phys., 01169 Dresden (DE); Holzherr, Martin, Dipl.Phys., 02681 Wilthen (DE); Bücken, Bernd, Dipl.Phys., 01277 Dresden (DE)
(74) Vertreter: Pätzelt, Peter

(56) Entgegenhaltungen:
- EP-A- 1 186 681
- DE-A1-0102004 015 23
- DE-C1- 4 228 499
- HOLZHERR M ET AL: "Combination of hollow cathode and vacuum arc plasma for effective hard material coatings on tools" PROC ANNU TECH CONF SOC VAC COATERS; PROCEEDINGS, ANNUAL TECHNICAL CONFERENCE - SOCIETY OF VACUUM COATERS; SVC, SOCIETY OF VACUUM COATERS 48TH ANNUAL TECHNICAL CONFERENCE PROCEEDINGS 2005, 2005, Seiten 452-457, XP008081516

## Beschreibung

Die Erfindung betrifft eine Einrichtung und ein Verfahren zur plasmagestützten Abscheidung von Hartstoffschichten, insbesondere zur Herstellung von Titan-Aluminium-Nitrid-Schichten nach dem Oberbegriff des Anspruchs 1 bzw. 6.

Nach dem Stand der Technik sind vielfältige Lösungen zur plasmagestützten Abscheidung von Hartstoffschichten bekannt. Die Auswahl der geeigneten Verdampferquelle richtet sich in der Regel nach der vorgegebenen technologischen Aufgabe. Von besonderer Bedeutung ist dabei die Erzeugung des Plasmas. Kathodenzerstäubungseinrichtungen und Vakuumbogenverdampfer (auch Lichtbogenverdampfer genannt) erzeugen verfahrensbedingt ein Plasma. Sehr oft ist jedoch die dabei erreichte Plasmadichte unzureichend.

Die DE 42 28 499 C1 beschreibt ein Verfahren und eine Einrichtung zur plasmagestützten Beschichtung von Substraten mittels eines Vakuumbogenverdampfers. Dabei wird vor und während der Beschichtung der Substrate aus dem Vakuumbogenverdampfer eine Niedervoltbogenentladung aufrecht erhalten. Die Anode der Vakuumbogenentladung und die Anode der Niedervoltbogenentladung sind als eine gemeinsame Elektrode ausgebildet. Vor der Beschichtung der Substrate mittels Vakuumbogenverdampfung kann die Niedervoltbogenentladung zur Plasmareinigung und Aufheizung der Substrate eingesetzt werden. Während der Beschichtung wird durch die Niedervoltbogenentladung die Plasmadichte in der Vakuumkammer erhöht, wodurch eine höhere Härte, eine bessere Homogenität und bessere Verschleißfestigkeit der plasmagestützt abgeschiedenen Beschichtung erreicht werden soll. Eine praxistaugliche Reproduzierbarkeit für eine bessere Schichtausbildung konnte jedoch nicht nachgewiesen werden.

Die DE 10 2004 015 320 A1 beschreibt ein Verfahren und eine Vorrichtung zum Intensivieren einer gepulsten Magnetronentladung. In einer Vakuumkammer sind peripher zur Anordnung der Substrate mindestens eine erste Elektrode und mindestens eine zweite Elektrode vorhanden, die wechselweise als Anode oder Kathode betrieben werden können. Zumindest für einen Teil jedes Zeitabschnittes, in dem die erste Elektrode nicht katodisch betrieben wird, wird ein zusätzlicher Elektronenstrom aus mindestens einer zusätzlichen Elektronenquelle auf die erste Elektrode gelenkt, so dass in der Umgebung der ersten Elektrode Ionen gebildet werden. Die Elektronenquelle kann u.a. eine Hohlkathode umfassen.

In der EP 1 186 681 A1 ist eine Vakuumanlage mit koppelbaren Werkstückträger offenbart. Die erfindungsgemäße Vakuumbehandlungsanlage umfasst in einem Rezipienten, in der zentralen Achse eine Niedervoltbogen-Entladungsvorrichtung, bestehend aus einer Ionisationskammer und einer Anode, sowie Verdampferquellen und Werkstückträger. Zum Stand der Technik wird eine Ausführung erläutert, bei der seitlich am Rezipienten und parallel zu beweglich auf einem Werkstückträger angebrachten Werkstückhaltern mindestens eine Niedervoltbogen-Entladungsanordnung, mit einer Ionisationskammer und einer Anode, vorgesehen ist.

Allgemein ist festzustellen, dass trotz der praktisch positiven Wirkung eines Plasmas die tatsächliche verfahrensspezifische Nutzung des Plasmas bei der plasmagestützten Abscheidung von dünnen Schichten außerordentlich kompliziert und schwierig ist. Das umfasst auch die Kenntnis der konkreten Wirkmechanismen des Plasmas und die praktischen Möglichkeiten der Beeinflussung des Plasmas.

Der Erfindung liegt als Aufgabe zugrunde, eine Einrichtung und ein Verfahren zur plasmagestützten Abscheidung von Hartstoffschichten anzugeben, mit denen eine hohe Reproduzierbarkeit einer hohen Härte, geringer Oberflächenrauigkeit und damit einer hohen Verschleißfestigkeit der Hartstoffschichten gewährleistet wird. Insbesondere soll die wirtschaftliche Herstellung von Titan-Aluminium-NitridSchichten mit einem hohen Aluminiumgehalt möglich sein und die Ablagerung von Droplets in der abgeschiedenen Schicht soll minimiert werden.

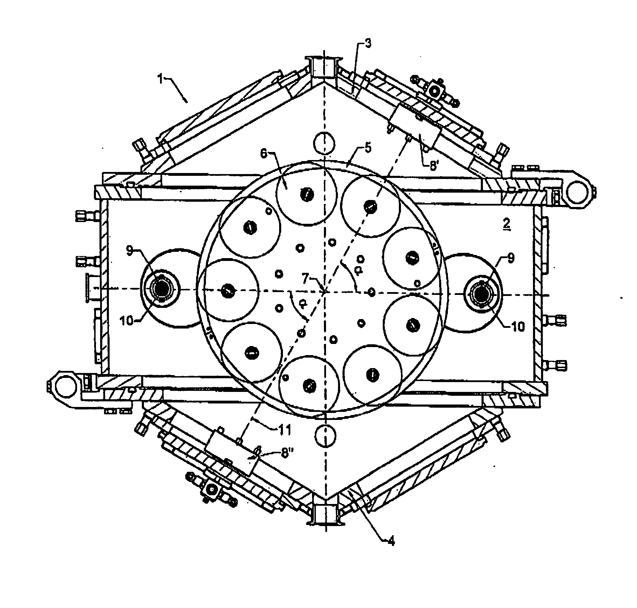

Die Erfindung löst die Aufgabe für die Einrichtung durch die im Anspruch 1 angegebenen Merkmale für das Verfahren durch die im Anspruch 6 angegebenen Merkmale. Vorteilhafte Weiterbildungen der Erfindung sind in den jeweiligen Unteransprüchen gekennzeichnet und werden nachstehend zusammen mit der Beschreibung der bevorzugten Ausführung der Erfindung, einschließlich der Zeichnung, näher dargestellt.

Die Erfindung beruht auf der überraschenden Erkenntnis, dass mit der erfindungsgemäßen spezifischen örtlichen Positionierung einer zusätzlichen Niedervoltbogenentladung gegenüber der Verdampfungsquelle und den Substraten hochwertige Hartstoffschichten reproduzierbar hergestellt werden können. Dieser Vorteil ist insbesondere bei Titan-Aluminium-Nitrid-Schichten mit einem erhöhten Aluminiumgehalt und minimierter Dropleteinlagerung nachweisbar.

Erfindungsgemäß ist eine als solche bekannte Einrichtung mit einer Vakuumkammer, einem um eine zentrische Achse rotierenden Substratträger zur Halterung von Substraten, mindestens einer radial außerhalb des Substratträgers angeordneten Verdampfungsquelle und mindestens einer Hohlkathode zur Erzeugung eines Niedervoltplasmas entsprechend der Merkmale des Anspruchs 1 ausgebildet.

Die Hohlkathode befindet sich wie die verdampfungsquelle radial außerhalb des Substratträgers, wobei die zur Hohlkathode gehörige Anode derart angeordnet ist, dass die Entladung des Hohlkathoden-Niedervoltplasmas parallel zum Substratträger ausbildet wird. Dabei ist diese Linie zwischen der Hohlkathode und der Anode gegenüber der Linie zwischen dem Target der Verdampfungsquelle und der Rotationsachse des Substratträgers in der Ebene rechtwinklig zur Rotationsachse des Substratträgers um einen Winkel zwischen 15° bis 70° versetzt angeordnet.

Als Verdampfungsquelle kann entsprechend der technologischen Gegebenheiten ein vakuumbogenverdampfer oder eine Kathodenzerstäubungseinrichtung eingesetzt werden.

Verfahrensgemäß wird mit einer Einrichtung nach dem Oberbegriff des Anspruchs 6 die Hohlkathodenentladung zur Erzeugung des Niedervoltplasmas radial außerhalb und parallel zur Achse des Substratträgers ausbildet, wobei die Linie zwischen der Hohlkathode und der zugehörigen Anode gegenüber der Linie zwischen dem Target der Verdampfungsquelle und der Rotationsachse des Substratträgers in der Ebene rechtwinklig zur Rotationsachse des Substratträgers um einen Winkel zwischen 15° bis 70° versetzt ausgebildet wird. Dabei besteht auch die Möglichkeit, zwischen zwei verdampfungsquellen, die beispielsweise mit einem Winkel von größer 30° zueinander angeordnet sind, nur eine Hohlkathode vorzusehen.

Die Hohlkathodenentladung wird parallel zur Verdampfung von Targetmaterial aus der Verdampfungsquelle aufrechterhalten. In bekannter Weise kann das Hohlkathodenplasma vor der Beschichtung auch zur Elektronenstoßheizung sowie zum Ionenätzen der Substrate eingesetzt werden.

in überraschender Weise wurde gefunden, dass auch bei einem allgemeinen Übergreifen des Niedervoltplasmas über die gesamte Vakuumkammer eine unmittelbare Wirksamkeit des Niedervoltplasmas auf die Substrate wie auf den Dampfstrom von der Verdampferquelle gegeben ist. Die enge aber örtlich um einen Winkel von 15° bis 70° zur Rotationsachse des Substrathalters versetzte Anordnung der Niedervoltbogenentladung gegenüber der Verdampferquelle bewirkt, dass die jeweils zuvor abgeschiedene Hartstoffschicht einem zusätzlichen Ionenbeschuss und damit einem Ätzprozess aus dem Niedervoltbogenplasma ausgesetzt wird. Wenn die rotierenden Substrate wieder in den Bereich der Beschichtung gelangen, erfolgt die Abscheidung bei hoher Plasmadichte auf einer vorteilhaft plasmageätzten Oberfläche. Die abgeschiedenen Schichten weisen eine sehr hohe Dichte und Härte auf.

Weiter wurde gefunden, dass die örtliche Nähe des Niedervoltplasmas zum Dampfstrom von der Verdampferquelle zu einer wesentlichen Verringerung der Droplets in den einzelnen abgeschiedenen Schichten führt.

Bei der Herstellung von Titan-Aluminium-NitridSchichten aus einem Titan-Aluminium-Targets mit einem in der Praxis vorteilhaften Teilchenverhältnis von 1:1 wurde überraschend festgestellt, dass in der abgeschiedenen Titan-Aluminium-Nitrid-Schicht wesentlich mehr Aluminiumteilchen eingebaut werden als bei Verfahren des Standes der Technik. Bei letzteren kann die Stöchiometrie (1:1) der Targetmaterialien in den abgeschiedenen Schichten nur schwierig beibehalten werden. Vielfach ist das Aluminium in der Schicht nur unterstöchimetrisch enthalten, was mit einer geringeren thermischen Belastbarkeit der Schicht verbunden ist.

Das Verfahren kann in entsprechender weise auch sehr vorteilhaft für die Herstellung andere Metall-Aluminium-Hartstoffschichten eingesetzt werden. So kann statt Titan auch Chrom, Zirkonium, Vanadium, Tantal u.ä. Metalle eingesetzt werden.

### Ausführungsbeispiel

Die Erfindung wird nachstehend an einem Ausführungsbeispiel näher erläutert. Die zugehörige Zeichnung zeigt einen Horizontalschnitt durch eine Vakuumbeschichtungsanlage 1 mit einer vertikalen Vakuumkammer 2, die zwei gegenüber liegende Kammertüren 3 und 4 aufweist. Zentrisch in der Vakuumkammer 2 ist ein Substratträger 5 mit neun Planeten 6 vorgesehen, der um die vertikale Achse 7 rotiert werden kann. Die zu beschichtenden Substrate sind unmittelbar an den Planeten 6 gehaltert.

In den Kammertüren 3 und 4 sind gegenüber liegend je ein Vakuumbogenverdampfer 8' und 8" angeordnet. Dabei ist im Ausführungsbeispiel der Vakuumbogenverdampfer 8' mit einem Titan-Target bestückt und der Vakuumbogenverdampfer 8" mit einem Titan-Aluminium-Target mit einem Ti-Al-Verhältnis von 1:1 ausgerüstet.

Innerhalb der Vakuumkammer 2 sind koaxial und außerhalb des Substratträgers 5 zwei Hohlkathoden 9 vorhanden. Zugeordnet zu den Hohlkathoden 9 befindet sich an der oberen Wand der Vakuumkammer 2 eine Anode (in der Zeichnung nicht sichtbar), derart dass sich radial außerhalb des Substratträgers 5 und parallel zur Achse 7 in einer Linie 10 (in der Zeichnung vertikal über der Hohlkathode 9) je eine Hohlkathodenbogenentladung ausbilden kann.

Dabei sind die Achsen 10 zwischen den Hohlkathoden 9 und der zugehörigen Anode gegenüber den Linien 11 zwischen den Targets der Vakuumbogenverdampfer 8' oder 8" und der Achse 7 des Substratträgers 5 in der Ebene rechtwinklig zur Achse 7 um einen Winkel α von beispielsweise 60° versetzt angeordnet.

In der Vakuumbeschichtungsanlage 1 können auch weitere Hohlkathoden und Vakuumbogenverdampfer angeordnet sein, wobei der Winkel α zwischen den Paarungen auch unterschiedlich sein kann. Die Vakuumbogenverdampfer können auch beide oder nur einer durch Kathodenzerstäubungseinrichtungen ersetzt sein.

Die vorstehend beschriebene Einrichtung soll nachfolgend in der verfahrensgemäßen Anwendung näher beschrieben werden. Beispielhaft soll auf einem HSS-Werkzeug (HSS - Hochleistungs-Schnellarbeitsstahl) zur Verbesserung des Verschleißechutzes ein Hartstoff-Schichtsystem bestehend aus einer ersten TiN-Schicht als Haftschicht und einer zweiten TiA1N-Schicht mit einem Ti:Al-Verhältnis von 40:60 als eigentliche funktionale Hartstoffschicht aufgebaut werden.

Nach der Bestückung der Planeten 6 im Substratträger 5 mit Substraten werden die Kammertüren 3 und 4 geschlossen und die Vakuumbeschichtungsanlage 1 wird auf einen Startdruck von <1,0 x 10⁻⁴ mbar evakuiert. Anschließend wird der Substratträger 5 mit 5 U/min in Rotation versetzt. Zum Aufheizen der Substrate werden zwischen den Hohlkathoden 9 und der Anode Niedervoltbogenentladungen mit einem Bogenstrom von 100 A gezündet. Dazu wird durch die Hohlkathoden 9 Argongas eingelassen und in der Vakuumbeschichtungsanlage 1 eine Argonatmosphäre mit einem Druck von 5,0 x 10⁻³ mbar eingestellt.

Danach werden die Substrate in bekannter Weise anodisch geschaltet und durch Elektronenbeschuss auf die technologisch vorgegebene Temperatur aufgeheizt. Diese Temperatur ist im Wesentlichen vom konkreten Substratmaterial abhängig. Im Ausführungsbeispiel werden die HSS-werkzeug-Substrate auf 450 °C aufgeheizt. Nachdem die Substrate die vorgegebene Temperatur erreicht haben, werden bei Aufrechterhaltung der Niedervoltbogenentladungen die Substrate an negatives Potential von -200 V gelegt, wodurch diese einer Ionenbeschussreinigung ausgesetzt werden.

Nach dieser bekannten Vorbehandlung der Substrate wird bei einer Niedervoltbogenentladung mit einem Bogenstrom von 90 A in der Vakuumbeschichtungsanlage 1 eine Stickstoffatmosphäre mit einem Druck von 1,0 x 10⁻² mbar eingestellt.

Danach wird zuerst die vorgegeben TiN-Schicht und danach die TiAlN-Schicht aufgebaut. Dazu werden die Substrate an ein negatives Potential von -150 V gelegt, der Vakuumbogenverdampfer 8' mit dem Ti-Target wird in Betrieb gesetzt und eine TiN-Schicht mit einer Schichtdicke von 0,3 µm abgeschieden. Der Vakuumbogenverdampfer 8' wird mit einem Bogenstrom von 80 A bei parallel bestehender Niedervoltbogenentladung von 150 A betrieben.

In unmittelbarer Folge wird der Vakuumbogenverdampfer 8' außer Betrieb und der Vakuumbogenverdampfer 8" mit dem TiAl-Target (Ti:Al-Verhältnis von 1:1) in Betrieb genommen. Die Bogenströme des Vakuumbogenverdampfers 8" sowie die parallele Niedervoltbogenentladung werden entsprechend dem Aufbau der TiN-Schicht eingestellt. In der Argon-Stickstoffatmosphäre wird die funktionelle TiAlN-Hartstoffschicht mit einer Dicke von 3,0 µm bei geringer Rauigkeit aufgebaut. Dabei weist die abgeschiedene TiAlN-Schicht ein Ti:AI-Verhältnis von mindestens 1:1 bis zu einem erhöhten Al-Anteil auf.

Erfindungsgemäß werden die im rotierenden Substratträger 5 gehalterten Substrate nacheinander dem direkten verdampfungsstrom der Vakuumbogenverdampfer 8' oder 8" und in der Folge der Niedervoltbogenentladung der Hohlkathoden 9 ausgesetzt. Dabei kommt es periodisch zur direkten Beschichtung mit dem Targetmaterial aus dem Vakuumbogenverdampfer 8' oder 8" und nachfolgend zu einem verstärkten Ionenbeschuss aus der Niedervoltbogenentladung der Hohlkathoden 9. Die Substrate werden somit zyklisch einer plasmagestützten Beschichtung und einer Ionenätzung ausgesetzt.

Mit dieser Verfahrensführung können außerordentlich harte Schichten abgeschieden werden. Die Schichten weisen auch eine geringe Oberflächenrauigkeit auf, was visuell an einer hohen Brillanz der Schicht erkennbar ist. Dabei wurde gefunden, dass mit dem erfindungsgemäßen Verfahren TiAIN-Schichten mit einem Ti:AL-Verhältnis von 50:50 bis 40:60 abgeschieden werden, obwohl Targets mit einem Ti:AL-Verhältnis von 1:1 eingesetzt werden. Nach dem Stand der Technik müssen zur Herstellung derartiger Schichten meist verfahrenstechnisch ungünstige pulvermetallurgisch hergestellte Targets eingesetzt werden, die einen beträchtlich höheren Al-Anteil aufweisen.

## Patentansprüche

1. Einrichtung zur plasmagestützten Abscheidung von Hartstoffschichten, bestehend aus einer Vakuumkammer, einen um eine zentrische Achse (7) rotierenden Substratträger (5) zur Halterung von Substraten, mindestens einer radial außerhalb des Substratträgers (5) angeordneten Verdampfungsquelle (8) und mindestens einer radial außerhalb des Substratträgers (5) angeordneten Hohlkathode (9) zur Erzeugung eines Niedervoltplasmas, **dadurch gekennzeichnet, dass**
- die Hohlkathode (9) radial außerhalb des Substratträgers (5) angeordnet ist,
- wobei die zur Hohlkathode (9) gehörige Anode derart positioniert ist, dass die Entladung des Hohlkathoden-Niedervoltplasmas parallel zum Substratträger (5) ausgebildet wird und
- die Linie (10) zwischen der Hohlkathode (9) und der zugehörigen Anode gegenüber der Linie (11) zwischen dem Target der Verdampfungsquelle und der Achse (7) in der Ebene rechtwinklig zur Achse (7) um 15° bis 70° versetzt ist.

2. Einrichtung nach Anspruch 1, **dadurch gekennzeichnet, dass** zwei bis vier Verdampfungsquellen mit je einer zugeordneten Hohlkathode (9) vorhanden sind.

3. Einrichtung nach Anspruch 1, **dadurch gekennzeichnet, dass** zwei bis vier Verdampfungsquellen vorhanden sind und zwischen je zwei benachbarten Verdampfungsquellen eine Hohlkathode vorgesehen ist.

4. Einrichtung nach einem der Ansprüche 1 bis 3, **dadurch gekennzeichnet, dass** die Verdampfungsquelle oder die Hohlkathode (9) in der Vakuumkammer (2) und die jeweils andere Einrichtung in der Tür (3, 4) der Vakuumkammer (2) angeordnet ist.

5. Einrichtung nach einem der Ansprüche 1 bis 4, **dadurch gekennzeichnet, dass** die Verdampfungsquelle ein Vakuumbogenverdampfer (8', 8'') oder eine Kathodenzerstäubungseinrichtung ist.

6. Verfahren zur plasmagestützten Abscheidung von Hartstoffschichten in einer Vakuumkammer mit einem um eine zentrische Achse (7) rotierenden Substratträger (5) zur Halterung der Substrate, mindestens einem außerhalb des Substratträgers (5) vorgesehenen Vakuumbogenverdampfer oder einer Rathodenzerstäubungseinrichtung als Verdampfungsquelle (8) und mindestens einer Hohlkathode (9) zur Erzeugung eines Niedervoltplasmas, **dadurch gekennzeichnet, dass**
- die Hohlkathodenbogenentladung zur Erzeugung des Niedervoltplasmas radial außerhalb und parallel zur Achse (7) des Substratträgers (5) ausgebildet wird, wobei
- die Linie (10) zwischen der Hohlkathode (9) und der zugehörigen Anode gegenüber der Linie (11) zwischen dem Target der Verdampfungsquelle und der Achse (7) in der Ebene rechtwinklig zur Achse (7) um 15° bis 70° versetzt angeordnet
- und die Hohlkathodenbogenentladung parallel zur Verdampfung von Targetmaterial aus der Verdampfungsquelle aufrechterhalten werden.

7. Verfahren nach Anspruch 6, **dadurch gekennzeichnet, dass** das Niedervoltplasma der Hohlkathodenbogenentladung parallel zur Abscheidung von Targetmaterial aus der Verdampfungsquelle auf die Substrate einwirkt.

8. Verfahren nach Anspruch 6 oder 7, **dadurch gekennzeichnet, dass** zur Herstellung einer Titan-AluminiumNitrid-Schicht innerhalb einer reaktiven Stickstoffatmosphäre mit einem Ti:Al-Anteil von 50:50 bis 40:60 ein Target mit einem Ti:Al-Anteil von 1:1 eingesetzt wird.

9. Verfahren nach einem der Ansprüche 6 bis 8, **dadurch gekennzeichnet, dass** die Substrathalterung mit einer derartigen Geschwindigkeit bewegt wird, dass die zu beschichtenden Substrate vor jeder Beschichtung im Wirkbereich einer Verdampferquelle im Wirkbereich des Niedervoltplasmas einem Plasma-Ätzprozess ausgesetzt wird.

10. Verfahren nach einem der Ansprüche 6 bis 9, **dadurch gekennzeichnet, dass** die Substrate gegenüber dem Niedervoltplasma an eine negative Spannung gelegt werden.

## Claims

1. Apparatus for plasma-enhanced deposition of hard material layers, comprising a vacuum chamber, a substrate carrier (5), rotating about a central axis (7), for holding substrates, at least one evaporation source (8), arranged radially outside the substrate carrier (5), and at least one hollow cathode (9), arranged radially outside the substrate carrier (5), for producing a low-voltage plasma, **characterized in that**
- the hollow cathode (9) is arranged radially outside the substrate carrier (5),
- the anode belonging to the hollow cathode (9) being positioned in such a way that the discharge of the hollow-cathode low-voltage plasma is formed parallel to the substrate carrier (5) and
- the line (10) between the hollow cathode (9) and the associated anode is offset with respect to the line (11) between the target of the evaporation source and the axis (7) in the plane at right angles to the axis (7) by 15° to 70°.

2. Apparatus according to Claim 1, **characterized in that** there are two to four evaporation sources, each with an assigned hollow cathode (9).

3. Apparatus according to Claim 1, **characterized in that** there are two to four evaporation sources and a hollow cathode is provided between every two adjacent evaporation sources.

4. Apparatus according to one of Claims 1 to 3, **characterized in that** the evaporation source or the hollow cathode (9) is arranged in the vacuum chamber (2) and the other device, respectively, is arranged in the door (3, 4) of the vacuum chamber (2).

5. Apparatus according to one of Claims 1 to 4, **characterized in that** the evaporation source is a vacuum arc evaporator (8', 8'') or a cathode sputtering device.

6. Method for plasma-enhanced deposition of hard material layers in a vacuum chamber with a substrate carrier (5), rotating about a central axis (7), for holding the substrates, at least one vacuum arc evaporator or a cathode sputtering device as the evaporation source (8), provided outside the substrate carrier (5), and at least one hollow cathode (9) for producing a low-voltage plasma, **characterized in that**
- the hollow cathode arc discharge for producing the low-voltage plasma is formed radially outside and parallel to the axis (7) of the substrate carrier (5),
- the line (10) between the hollow cathode (9) and the associated anode being offset with respect to the line (11) between the target of the evaporation source and the axis (7) in the plane at right angles to the axis (7) by 15° to 70°,
- and the hollow cathode arc discharge being maintained parallel to the evaporation of target material from the evaporation source.

7. Method according to Claim 6, **characterized in that** the low-voltage plasma of the hollow cathode arc discharge acts on the substrates parallel to the deposition of target material from the evaporation source.

8. Method according to Claim 6 or 7, **characterized in that**, to produce a titanium-aluminium-nitride layer within a reactive nitrogen atmosphere with a Ti:Al ratio of 50:50 to 40:60, a target with a Ti:Al ratio of 1:1 is used.

9. Method according to one of Claims 6 to 8, **characterized in that** the substrate holder is moved at such a speed that, before each coating in the active area of an evaporator source, the substrates to be coated are subjected to a plasma etching process in the active area of the low-voltage plasma.

10. Method according to one of Claims 6 to 9, **characterized in that** the substrates are connected to a negative voltage with respect to the low-voltage plasma.

## Revendications

1. Dispositif de dépôt par plasma de couches de matériau dur, se composant d'une chambre à vide, d'un support de substrats (5) tournant autour d'un axe central (7) et destiné à porter des substrats, d'au moins une source de vaporisation (8) disposée radialement à l'extérieur du support de substrats (5) et d'au moins une cathode creuse (9) disposée radialement à l'extérieur du support de substrats (5) pour produire un plasma à basse tension, **caractérisé en ce que**
- la cathode creuse (9) est disposée radialement à l'extérieur du support de substrats (5),
- dans lequel l'anode correspondant à la cathode creuse (9) est positionnée de telle manière que la décharge du plasma à basse tension de la cathode creuse soit formée parallèlement au support de substrats (5), et
- la ligne (10) entre la cathode creuse (9) et l'anode correspondante est décalée de 15° à 70°, dans le plan perpendiculaire à l'axe (7), par rapport à la ligne (11) entre la cible de la source de vaporisation et l'axe (7).

2. Dispositif selon la revendication 1, **caractérisé en ce qu'**il comporte deux à quatre sources de vaporisation ayant chacune une cathode creuse associée (9).

3. Dispositif selon la revendication 1, **caractérisé en ce qu'**il comporte deux à quatre sources de vaporisation et il est chaque fois prévu une cathode creuse entre deux sources de vaporisation voisines.

4. Dispositif selon l'une quelconque des revendications 1 à 3, **caractérisé en ce que** la source de vaporisation ou la cathode creuse (9) est disposée dans la chambre à vide (2) et l'autre dispositif respectif est disposé dans la porte (3, 4) de la chambre à vide (2).

5. Dispositif selon l'une quelconque des revendications 1 à 4, **caractérisé en ce que** la source de vaporisation est un évaporateur à arc sous vide (8', 8") ou un dispositif de pulvérisation cathodique.

6. Procédé de dépôt par plasma de couches de matériau dur dans une chambre à vide avec un support de substrats (5) tournant autour d'un axe central (7) et destiné à porter les substrats, au moins un évaporateur à arc sous vide ou un dispositif de pulvérisation cathodique comme source de vaporisation (8) disposée radialement à l'extérieur du support de substrats (5) et au moins une cathode creuse (9) pour produire un plasma à basse tension, **caractérisé en ce que**
- la décharge d'arc de la cathode creuse pour produire le plasma à basse tension est réalisée radialement à l'extérieur et parallèlement à l'axe (7) du support de substrats (5), dans lequel
- la ligne (10) entre la cathode creuse (9) et l'anode correspondante est disposée avec un décalage de 15° à 70°, dans le plan perpendiculaire à l'axe (7), par rapport à la ligne (11) entre la cible de la source de vaporisation et l'axe (7), et
- la décharge d'arc de la cathode creuse est maintenue parallèlement à la vaporisation de matériau cible à partir de la source de vaporisation.

7. Procédé selon la revendication 6, **caractérisé en ce que** le plasma à basse tension de la décharge d'arc de la cathode creuse agit parallèlement au dépôt de matériau cible à partir de la source de vaporisation sur les substrats.

8. Procédé selon la revendication 6 ou 7, **caractérisé en ce que**, pour la production d'une couche de nitrure d'aluminium-titane à l'intérieur d'une atmosphère réactive d'azote avec une proportion Ti:Al de 50:50 à 40:60, on utilise une cible avec une proportion Ti:Al de 1:1.

9. Procédé selon l'une quelconque des revendications 6 à 8, **caractérisé en ce que** le support de substrats est déplacé avec une vitesse telle que les substrats à revêtir soient, avant chaque revêtement dans la zone d'action d'une source de vaporisation, soumis à un processus d'attaque au plasma dans la zone d'action du plasma à basse tension.

10. Procédé selon l'une quelconque des revendications 6 à 9**, caractérisé en ce que** les substrats sont portés à une tension négative par rapport au plasma à basse tension.
